# FASCICULE DE BREVET EUROPEEN

(11) **EP 0 821 411 B1**
(45) Date de publication et mention de la délivrance du brevet: **21.05.2003**
(21) Numéro de dépôt: 97410081.0
(22) Date de dépôt: 24.07.1997
(51) Int. Cl.: H01L 27/07

(54) **Assemblage monolithique d'un transistor IGBT et d'une diode rapide**
Monolithische Anordnung eines IGBT-Transistors und einer schnellen Diode
Monolithic assembly of an IGBT transistor and a fast diode

(30) Priorité: 26.07.1996 FR 9609680
(43) Date de publication de la demande: 28.01.1998
(73) Titulaire: STMicroelectronics S.A., 92120 Montrouge (FR)
(72) Inventeur: Quoirin, Jean-Baptiste, 37100 Tours (FR)
(74) Mandataire: de Beaumont, Michel

(56) Documents cités:
- US-A- 5 183 769
- US-A- 5 273 917
- US-A- 5 278 443
- PATENT ABSTRACTS OF JAPAN vol. 005, no. 091 (E-061), 13 juin 1981 & JP 56 035473 A (NIPPON TELEGR & TELEPH CORP), 8 avril 1981,

## Description

La présente invention concerne un assemblage monolithique d'une diode rapide et d'un transistor IGBT.

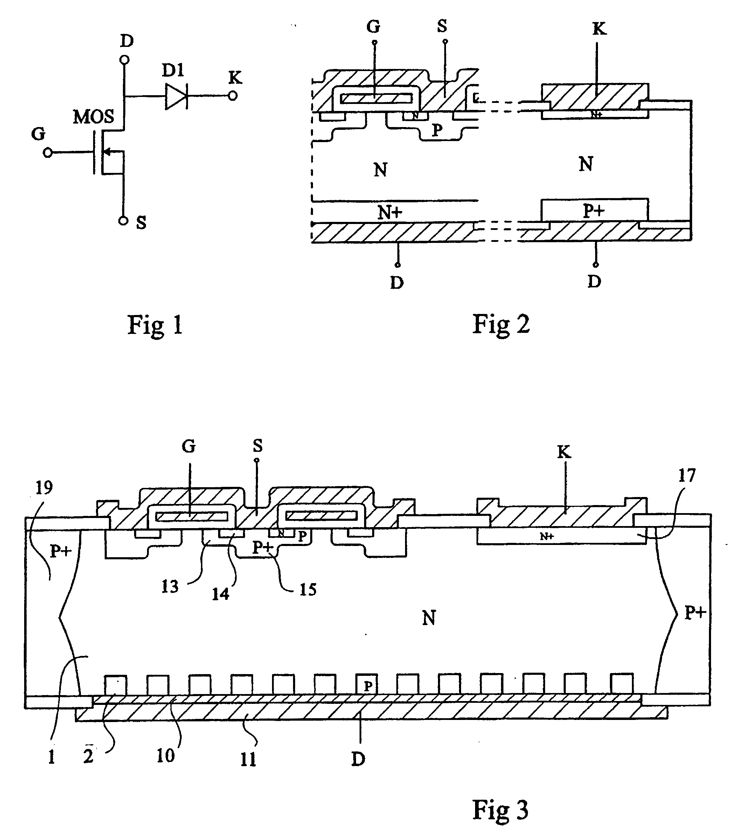

Dans de nombreux circuits, on trouve des connexions de composants du type de celle illustrée en figure 1 comportant un transistor MOS de puissance dont le drain est relié à l'anode d'une diode. Cette configuration se retrouve notamment dans des circuits surélévateurs de tension (Booster) tels que ceux utilisés dans des circuits convertisseurs alternatif-continu ou continu-continu. Dans ces applications, le transistor MOS doit supporter une tension relativement élevée et la diode doit être extrêmement rapide.

Ceci pose des problèmes d'intégration. En effet, la figure 2 représente, dans sa partie gauche, la structure classique d'une cellule d'un transistor MOS vertical et, dans sa partie droite, la structure classique d'une diode verticale. En figures 1 et 2, on a désigné par les mêmes références G, S, D et K la grille, la source et le drain du transistor MOS et la cathode de la diode.

Pour que la diode soit rapide, son substrat N doit être dopé à l'or ou au platine ou soumis à un autre traitement destiné à accélérer sa rapidité. Ces traitements sont difficiles à réaliser sur une partie seulement d'un composant. Ainsi, si l'on réalise un composant unique intégrant la diode et le transistor MOS, ces traitements réduisent la tenue en tension du transistor MOS haute tension et augmentent la valeur de sa résistance à l'état passant.

Les documents US-A-5 273 917 et US-A-5 183 769 décrivent un assemblage monolithique de plusieurs IGBT verticaux comprenant une structure de face arrière comprenant une couche de type P munie de nombreuses ouvertures qui permet des contacts Schottky et ohmique, ce qui améliore l'injection de porteurs dans le substrat.

Un objet de la présente invention est de réaliser de façon monolithique l'assemblage de la figure 1 de façon à obtenir une diode rapide sans nuire aux caractéristiques du transistor MOS.

La demanderesse a déjà proposé dans la demande de brevet français non-publiée N° 95/07737 du 22 juin 1995 de réaliser une diode rapide sur un même substrat qu'un autre composant vertical en choisissant la diode rapide de type Schottky/bipolaire.

On va montrer qu'une telle structure est particulièrement adaptée à la résolution du problème posé selon la présente invention où elle apporte des avantages spécifiques et une grande simplicité de fabrication.

Plus particulièrement l'objet de la présente invention est atteint par un assemblage monolithique tel que décrit dans la revendication 1.

Selon un mode de réalisation de la présente invention, la périphérie de la structure est occupée par une diffusion profonde de type P.

Ces objets, caractéristiques et avantages, ainsi que d'autres de la présente invention seront exposés en détail dans la description suivante d'un mode de réalisation particulier faite, à titre non-limitatif, en relation avec les figures jointes parmi lesquelles :
la figure 1 représente un circuit que la présente invention vise à réaliser sous forme monolithique ;
la figure 2 représente un mode de réalisation classique sous forme monolithique d'un tel circuit ; et
la figure 3 représente un assemblage monolithique selon la présente invention d'un circuit similaire au circuit de la figure 1.

Les vues en coupe schématique des figures 2 et 3 ne sont pas représentées à l'échelle comme cela est classique dans le domaine de la représentation des composants semiconducteurs.

Selon un aspect de la présente invention, on substitue au transistor MOS un transistor IGBT. On montrera que ceci permet une intégration plus simple. En outre, du point de vue circuit, ceci permet de tenir une tension en inverse (alors qu'une diode PN existe de façon inhérente entre la source et le drain d'un transistor MOS).

Comme le représente la figure 3, la présente invention prévoit une structure formée sur un substrat 1 de type N. Dans la partie gauche de la figure est constitué un transistor IGBT vertical et dans la partie droite une diode rapide verticale.

La face arrière du substrat 1 est revêtue d'une couche 2 de type P munie de très nombreuses ouvertures dimensionnées de la façon indiquée dans la demande de brevet citée ci-dessus.

Cette face arrière est revêtue d'une métallisation 10 propre à établir un contact ohmique avec les régions de type P et un contact Schottky avec les régions de type N faiblement dopées. Cette métallisation 10 est revêtue d'une métallisation 11, par exemple en aluminium.

Dans la partie supérieure de la figure, on retrouve une structure classique de cellule de transistor MOS vertical comprenant une région 13 de type P à l'intérieur de laquelle sont formés des anneaux 14 de type N. La partie centrale de la région de type P, sensiblement au centre des anneaux 14, est constituée d'une région 15 de type P plus fortement dopée. Au-dessus des parties de la région 13 situées entre la périphérie externe des anneaux 14 et les parties apparentes du substrat est formée une métallisation de grille G séparée de la surface du substrat de silicium par une couche d'oxyde mince. Une métallisation S est en contact avec la surface supérieure d'une portion au moins des anneaux 14 de type N et de la région centrale 15.

Etant donnée la présence de la couche 2 constituée de zones de type P sur la face inférieure du substrat, cette structure fonctionne comme un transistor IGBT en injectant des charges de porteurs minoritaires h⁺ dans le matériau N, ce qui fait baisser sa résistivité et permet d'avoir ainsi une résistance à l'état passant bien plus faible que celle d'un transistor MOS classique. Par contre, l'existence d'une jonction Schottky entre les zones de type P permet d'améliorer la commutation du transistor IGBT. En effet, le courant nominal passant dans la structure IGBT est constitué dans ce cas en partie de charges injectées dans la jonction Schottky (qui ne sont pas stockées car ce sont des porteurs majoritaires) et en partie de charges injectées par la jonction P⁺/N (qui sont stockées car ce sont des porteurs minoritaires). Par rapport à une structure IGBT classique où la jonction P⁺/N occupe toute la surface de la face arrière, le stock de charges à évacuer est beaucoup plus faible et donc la commutation beaucoup plus rapide. On voit ainsi que l'intégration d'une diode rapide à un transistor MOS, à condition que la rapidité de la diode soit réalisée par une association de diodes Schottky/bipolaire, transforme ce transistor MOS d'une part en un IGBT d'où un gain en surface de silicium pour une résistance à l'état passant identique, d'autre part en un transistor IGBT rapide sans devoir recourir aux traitements classiques (irradiation, dopage or ou platine) utilisés pour diminuer la quantité de charges stockées.

Dans la partie droite de la figure, on trouve à la partie supérieure de la tranche une région 17 de type N⁺ reliée à une métallisation K de cathode d'une diode.

Ainsi, selon un avantage de la présente invention, grâce à une configuration de type Schottky/bipolaire sur la face inférieure, on améliore simultanément le fonctionnement de la diode et le fonctionnement du transistor IGBT. Une telle structure est facile à fabriquer puisque le même traitement est réalisé sur toute la face inférieure.

On a en outre représenté en figure 1 des diffusions profondes 19 de type P⁺ à la périphérie du dispositif pour en améliorer l'isolement et la tenue en tension et pour éviter tout risque de court-circuit au cas où la brasure de fixation de la face arrière sur un radiateur déborderait latéralement.

Il est important de noter que les diffusions profondes 19 ne doivent pas être connectées électriquement à l'anode Schottky/bipolaire de la diode intégrée afin d'éviter l'injection de charges supplémentaires. Les diffusions 19 doivent être isolées par un oxyde comme cela est montré sur la figure 2.

L'homme de l'art notera que, en pratique, du côté de la face supérieure du substrat, on utilisera un grand nombre de cellules 13, 14, 15 pour obtenir un transistor de puissance désirée.

Bien entendu, chacun des éléments de la présente invention est susceptible de diverses variantes couramment appliquées aux composants de même nature de l'art antérieur.

On notera également que l'on peut en outre appliquer à la structure selon la présente invention un léger dopage par des ions métalliques pour en améliorer encore la rapidité.

A titre d'exemple, on pourra réaliser une structure selon la présente invention en utilisant les données ci-après (xⱼ désignant une profondeur de diffusion et Cₛ une concentration en surface) :
- épaisseur des plaquettes : entre 80 µm et 240 µm selon la tension qui couvre le domaine de 600 V à 1200 V,
- structure Schottky bipolaire de la face arrière : zones de 6 µm espacées de 6 µm avec xⱼ = 5 µm et Cₛ = 5.10¹⁸,
- les structures de la face avant sont celles d'un MOS vertical classique, c'est-à-dire :

| | |
|---|---|
| xⱼP⁺ = 5 µm | Cₛ = 1.10¹⁹ |
| xⱼP = 3 µm | Cₛ = 1.10¹⁷ |
| xⱼN⁺ = 1 µm | Cₛ = 5.10¹⁹, |
| épaisseur de grille 500 Å, | |
| taille des cellules 25 µm, | |

- la surface de la structure est ajustée pour tenir une intensité de courant allant de 3 A à 50 A selon une densité de 2 A/mm².

## Revendications

1. Assemblage monolithique d'un transistor IGBT vertical et d'une diode rapide verticale connectée au drain du transistor IGBT, réalisé dans un substrat semiconducteur de type N, la face arrière de la structure étant uniformément constituée d'une couche (2) de type P munie de nombreuses ouvertures à travers lesquelles apparaît le substrat (1) de type N, cette face arrière étant recouverte d'un matériau (10) propre à établir un contact Schottky avec le substrat et un contact ohmique avec la couche de type P, **caractérisé en ce que** cette structure de face arrière s'étend non seulement en regard de cellules de transistor MOS vertical formées sur la face avant, mais également en regard d'une région de type N⁺ (17) formée sur cette même face avant et constituant la cathode de ladite diode.

2. Assemblage selon la revendication 1, **caractérisé en ce que** la périphérie de la structure est occupée par une diffusion profonde (19) de type P.

## Patentansprüche

1. Monolithische Anordnung eines vertikalen IGBT-Transistors und einer mit dem Drainanschluß des IGBT-Transistors verbundenen vertikalen schnellen Diode, in Ausbildung in einem Halbleitersubstrat vom N-Typ, wobei die Rück- bzw. Unterseite des Gebildes gleichförmig von einer Schicht (2) vom P-Typ gebildet wird, die mit zahlreichen Öffnungen versehen ist, durch welche hindurch das Substrat (1) vom N-Typ freiliegt, und wobei diese Rück- bzw.Unterseite mit einem geeigneten Material (10) zur Herstellung eines Schottky- Kontakts mit dem Substrat und eines ohmschen Kontakts mit der Schicht vom P-Typ überzogen ist, **dadurch gekennzeichnet, dass** sich diese Struktur der Rück- bzw. Unterseite nicht nur in Ausrichtung mit den an der Vorder- bzw. Oberseite ausgebildeten Zellen des vertikalen MOS-Transistors erstreckt, sondern auch in Ausrichtung mit einem Bereich (17) vom N+ Typ, der an dieser selben Vorder- bzw. Oberseite ausgebildet ist und die Kathode der genannten Diode bildet.

2. Anordnung nach Anspruch 1, **dadurch gekennzeichnet, dass** der Umfang des Gebildes von einer tiefen Diffusion (19) vom P-Typ eingenommen wird.

## Claims

1. A monolithic assembly of a vertical IGBT transistor and a vertical fast diode connected to the drain of the IGBT transistor, implemented in an N-type semiconductor substrate, the rear surface of the structure being uniformly comprised of a P-type layer (2) having several openings through which the N-type substrate (1) appears, this rear surface being covered with a material (10) for establishing a Schottky contact with the substrate and an ohmic contact with the P-type layer,
**characterized in that** this rear surface structure extends not only in register with the cells of the vertical MOS transistor formed on the front surface, but also in register with an N⁺ region (17) formed on the same front surface and constituting the cathode of said diode.

2. An assembly according to claim 1, **characterized in that** the circumference of the structure is occupied by a P-type drive-in (19).
